(19)

Europäisches Patentamt
European Patent Office
Office européen des brevets

(11) **EP 4 227 715 A1**

(12) **EUROPEAN PATENT APPLICATION**
published in accordance with Art. 153(4) EPC

(43) Date of publication:
**16.08.2023 Bulletin 2023/33**

(21) Application number: **20957594.3**

(22) Date of filing: **12.10.2020**

(51) International Patent Classification (IPC):
*G02B 3/00* (2006.01)     *H01L 27/146* (2006.01)
*H04N 5/369* (2011.01)     *H04N 9/07* (2006.01)

(52) Cooperative Patent Classification (CPC):
**G02B 3/00; H01L 27/146; H04N 23/12; H04N 25/70**

(86) International application number:
**PCT/JP2020/038499**

(87) International publication number:
**WO 2022/079765 (21.04.2022 Gazette 2022/16)**

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**
Designated Extension States:
**BA ME**
Designated Validation States:
**KH MA MD TN**

(71) Applicant: **Nippon Telegraph And Telephone Corporation**
**Chiyoda-ku**
**Tokyo 100-8116 (JP)**

(72) Inventors:
• **MIYATA, Masashi**
  **Musashino-shi, Tokyo 180-8585 (JP)**
• **NEMOTO, Naru**
  **Musashino-shi, Tokyo 180-8585 (JP)**
• **NAKAJIMA, Mitsumasa**
  **Musashino-shi, Tokyo 180-8585 (JP)**
• **HASHIMOTO, Toshikazu**
  **Musashino-shi, Tokyo 180-8585 (JP)**

(74) Representative: **Hoffmann Eitle**
**Patent- und Rechtsanwälte PartmbB**
**Arabellastraße 30**
**81925 München (DE)**

(54) **OPTICAL ELEMENT, IMAGING ELEMENT, AND IMAGING DEVICE**

(57)     An optical element array (120) includes: a transparent layer (150) for covering a pixel (130) including a photoelectric conversion element; a plurality of columnar structures (160) which are disposed on the transparent layer (150) or in the transparent layer (150) in a plane direction of the transparent layer (150) and guide an incident light to the corresponding photoelectric conversion element, wherein the plurality of columnar structures (160) are formed on an entire surface of the transparent layer (150) at intervals shorter than a wavelength of the incident light.

Fig. 3

EP 4 227 715 A1

**Description**

[Technical Field]

The present invention relates to an optical element, an imaging element and an imaging apparatus.

[Background Art]

A typical imaging apparatus acquires a two-dimensional image including intensity information and color information about light from a subject by using a lens optical system and two-dimensional imaging elements such as a CCD (Charge Coupled Device) sensor and a CMOS (Complementary Metal Oxide Semiconductor) sensor.

In the imaging apparatus, a color filter corresponding to each pixel is provided on a pixel array having pixels including photoelectric conversion elements arranged in a two-dimensional array to perform color separation of incident light on each pixel including the photoelectric conversion elements. In the imaging apparatus, an on-chip microlens (hereinafter referred to as an on-chip lens) is formed on the color filter to improve sensitivity characteristics, and light is condensed on the photoelectric conversion element by the on-chip lens on which light is incident.

[Citation List]

[Patent Literature]

[PTL 1] Japanese Laid-open Patent Publication No. 2012-084608

[Summary of Invention]

[Technical Problem]

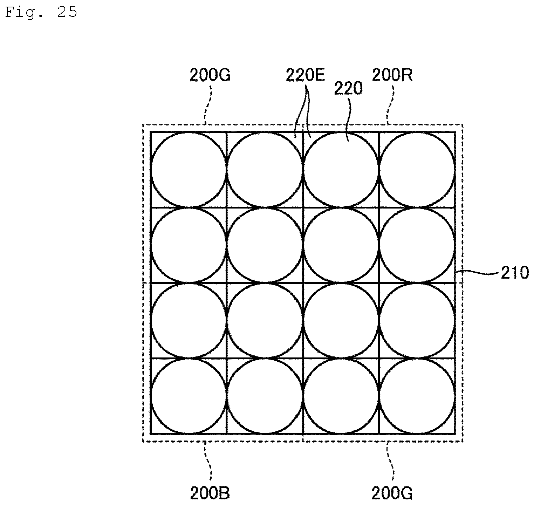

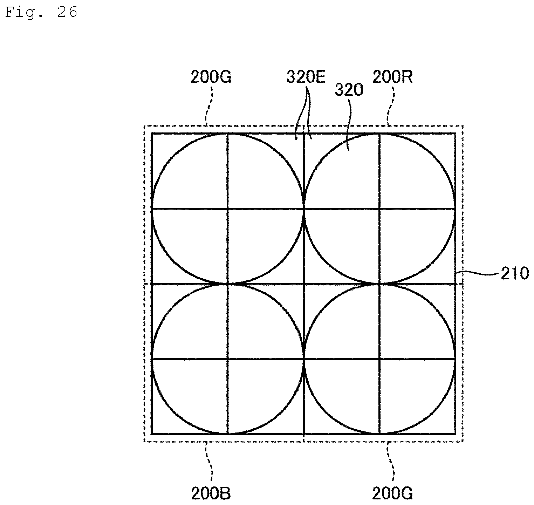

Figs. 25 and 26 are plan views of the on-chip lens. As illustrated in Figs. 25 and 26, an on-chip lens 220 or an on-chip lens 320 is formed on each of pixels 200R, 200G, and 200B of the pixel array 210. However, gaps 220E and 320E are each provided between the on-chip lenses 220 and the on-chip lenses 320. Since the light made incident outside a lens aperture region such as the gaps 220E and 320E between the lenses cannot be effectively condensed on the photoelectric conversion element, all the incident light cannot be received by the conventional on-chip lenses 220 and 320, and the light-receiving efficiency is limited.

The present invention has been made in view of this problem, and an object of the present invention is to provide an optical element, an imaging element and an imaging apparatus that can improve light-receiving efficiency as compared with the conventional case.

[Solution to Problem]

In order to solve the above-mentioned problem and achieve the object, an optical element according to the present invention includes: a transparent layer for covering a pixel including a photoelectric conversion element; and a plurality of columnar structures which are disposed on the transparent layer or in the transparent layer in a plane direction of the transparent layer and guide incident light to the corresponding photoelectric conversion element, in which the plurality of columnar structures are formed on an entire surface of the transparent layer at intervals shorter than a wavelength of the incident light.

The imaging element according to the present invention includes the aforementioned optical element, and a plurality of pixels each including a photoelectric conversion element.

An imaging apparatus according to the present invention includes the aforementioned imaging element; and a signal processing unit which processes an electric signal output from the imaging element and generates an image.

[Advantageous Effects of Invention]

According to the present invention, it is possible to provide an imaging element and an imaging apparatus capable of improving light-receiving efficiency compared to a conventional one.

[Brief Description of Drawings]

[Fig. 1] Fig. 1 is a side view illustrating a schematic configuration of an imaging apparatus according to an embodiment.

[Fig. 2] Fig. 2 is a diagram that schematically shows a part of cross sections of a pixel array and a polarized wavelength separating lens array of the imaging element according to the embodiment.

[Fig. 3] Fig. 3 is a diagram that schematically shows parts of cross sections of the pixel array and the optical element array in a central part of the imaging element according to the embodiment.

[Fig. 4] Fig. 4 is a diagram that schematically shows parts of cross sections of the pixel array and the optical element array in an outer peripheral part of the imaging element according to the embodiment.

[Fig. 5] Fig. 5 is a top view of the optical element array in the central part of the imaging element according to the embodiment.

[Fig. 6] Fig. 6 is a diagram illustrating a minimum structure height and a maximum aspect ratio of a medium-like approximation structure in the related art and a columnar structure in the embodiment.

[Fig. 7] Fig. 7 is a side view of the columnar structure.

[Fig. 8] Fig. 8 is a plan view of the columnar structure.

[Fig. 9] Fig. 9 is a diagram illustrating a relationship between a width of the columnar structure and the transmittance of light.

[Fig. 10] Fig. 10 is a diagram illustrating a relationship between the width of the columnar structure and the phase characteristics of the light of the columnar structure.

[Fig. 11] Fig. 11 is a diagram illustrating a definition of an incidence angle.

[Fig. 12] Fig. 12 is a diagram illustrating a phase distribution of a design target of a lens when light enters at an incidence angle of $\theta=0°$, $\phi=0°$, and a lens pattern for achieving the phase distribution.

[Fig. 13] Fig. 13 is a diagram illustrating a phase distribution of a design target of a lens when light enters at an incidence angle of $\theta=45°$, $\phi=0°$, and a lens pattern for achieving the phase distribution.

[Fig. 14] Fig. 14 is a diagram illustrating a phase distribution of a design target of a lens when light enters at an incidence angle of $\theta=45°$, $\phi=45°$, and a pattern for achieving the phase distribution.

[Fig. 15] Fig. 15 is a diagram illustrating condensing intensity by the optical element unit and its wavelength dependency.

[Fig. 16] Fig. 16 is a diagram illustrating the condensing intensity by the optical element unit and its wavelength dependence.

[Fig. 17] Fig. 17 is a diagram illustrating the condensing intensity by the optical element unit and its wavelength dependency.

[Fig. 18] Fig. 18 is a diagram illustrating the condensing intensity by the optical element unit and the incidence angle dependency of the incident light when parallel light of $\phi=0°$ ($\lambda=520$ nm) enters.

[Fig. 19] Fig. 19 is a diagram illustrating the condensing intensity by the optical element unit and the incidence angle dependency of the incident light when parallel light of $\phi=0°$ ($\lambda=520$ nm) enters.

[Fig. 20] Fig. 20 is a diagram illustrating the condensing intensity by the optical element unit and the incidence angle dependency of the incident light when parallel light of $\phi=0°$ ($\lambda=520$ nm) enters.

[Fig. 21] Fig. 21 is a diagram illustrating the condensing intensity by the optical element unit and the incidence angle dependency of the incident light when parallel light of $\phi=45°$ ($\lambda=520$ nm) enters.

[Fig. 22] Fig. 22 is a diagram illustrating the condensing intensity by the optical element unit and the incidence angle dependency of the incident light when parallel light of $\phi=45°$ ($\lambda=520$ nm) enters.

[Fig. 23] Fig. 23 is a diagram illustrating the condensing intensity by the optical element unit and the incidence angle dependency of the incident light when parallel light of $\phi=45°$ ($\lambda=520$ nm) enters.

[Fig. 24] Fig. 24 is a diagram which schematically shows another example of parts of cross sections of the pixel array and the optical element array of the imaging element according to the embodiment.

[Fig. 25] Fig. 25 is a plan view of an on-chip lens.

[Fig. 26] Fig. 26 is a plan view of the on-chip lens.

[Description of Embodiments]

The most appropriate embodiment according to the present invention will be described below with reference to the drawings. Note that, in the following description, shape, size, and positional relationship are roughly illustrated for facilitating the understanding, therefore the present invention is not limited to the illustrated shape, size, and positional relationship in the drawings. In addition, in the description of the drawings, like elements are designated with like reference numerals.

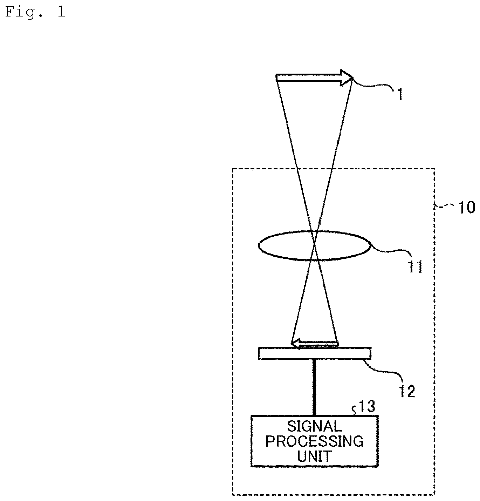

[Embodiment] [Imaging Apparatus] First, an imaging apparatus according to an embodiment of the present invention will be described below. Fig. 1 is a side view illustrating the schematic configuration of an imaging apparatus according to an embodiment.

As illustrated in Fig. 1, an imaging apparatus 10 according to the embodiment includes a lens optical system 11, an imaging element 12, and a signal processing unit 13. The imaging element 12 has a photoelectric conversion element, such as a CCD or a CMOS. The signal processing unit 13 processes a photoelectric conversion signal that is output from the imaging element 12 to generate an image signal.

An object 1 is irradiated with light such as natural light and illumination light, and light transmitted/reflected/scattered from the object 1 or light emitted from the object 1 forms an optical image on the imaging element 12 through the lens optical system 11. Typically, in order to correct various optical aberrations, the lens optical system 11 includes a lens set composed of a plurality of lenses placed along the optical axis. Fig. 1 is simplified to illustrate the lens optical system 11 as a single lens. The signal processing unit 13 has an image signal output for transmitting the generated image signal to the outside.

The imaging apparatus 10 may be provided with known constituent elements such as an optical filter for cutting infrared light, an electronic shutter, a view finder, a power source (battery), and a flashlight. The description thereof is omitted because the description is not particularly necessary for understanding of the present invention. The foregoing configuration is merely exemplary. Known elements may be properly used in combination as constituent elements other than the lens optical system 11, the imaging element 12, and the signal processing unit 13.

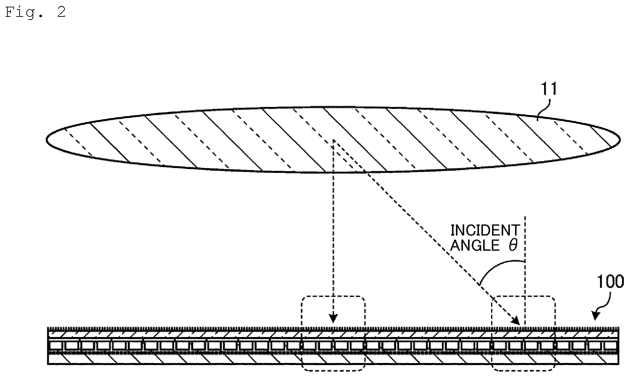

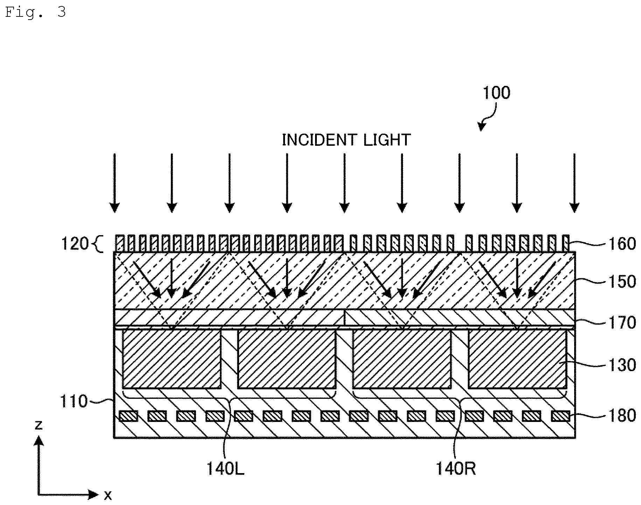

[Imaging Element] Next, the outline of the imaging element 12 according to the embodiment will be described. Fig. 2 is a view schematically illustrating a cross-section of main portions of the lens optical system 11 and the imaging element 12 according to the embodiment. In Fig. 2 and later, a part of the imaging element 12 will be described as the imaging element 100. The imaging element 100 has an optical element array (optical element) on a color filter, the optical element array being made up of a plurality of columnar structures for guiding incident light to the photoelectric conversion element of the pixel array on an entire surface of the optical element. Further, in the imaging element 100, as illustrated in Fig. 2, since an incidence angle θ of light incident from the lens optical system 11 to the imaging element 100 is different between a central part and an outer peripheral part, the plurality of columnar structures formed in the optical element array are set to a size that gives phase characteristics for guiding the columnar structures to the photoelectric conversion elements immediately below depending on the incidence angle of the incident light. Hereinafter, a plurality of configurations of the imaging element 100 will be described with reference to Figs. 3 to 5.

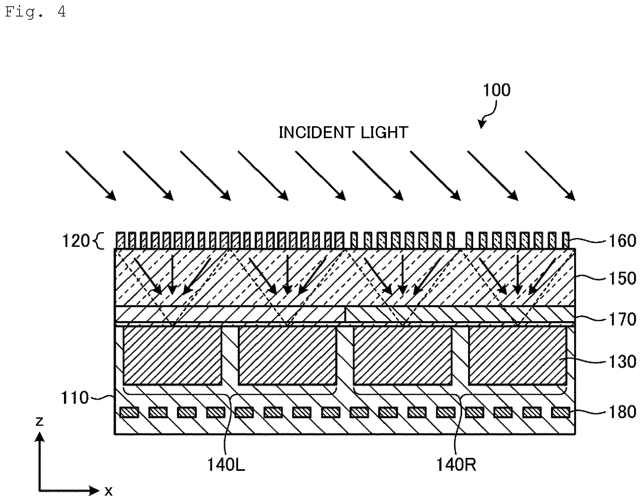

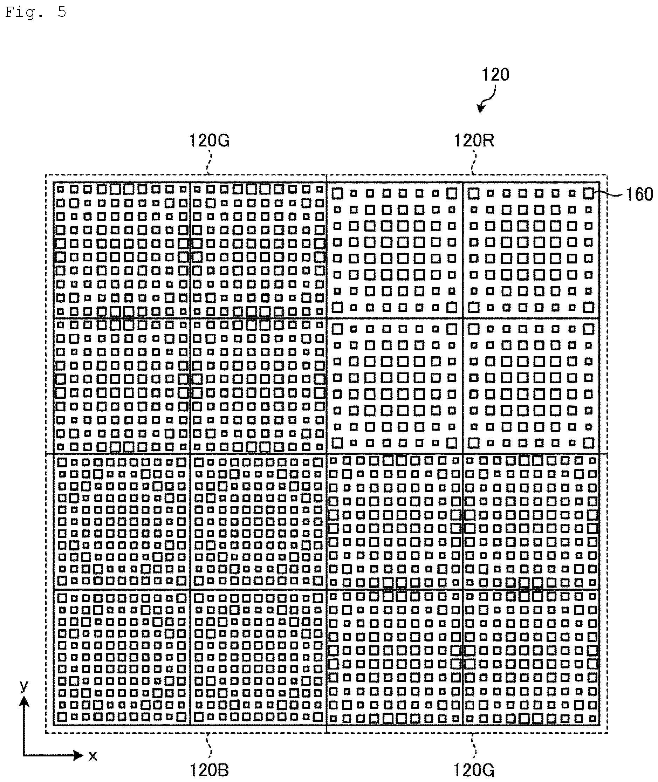

Fig. 3 is a diagram which schematically illustrates a part of the cross sections of the pixel array and the optical element array in the central part of the imaging element according to the embodiment. Fig. 4 is a diagram which schematically illustrates a part of the cross sections of the pixel array and the optical element array in the outer peripheral part of the imaging element according to the embodiment. Fig. 5 is a top view of the optical element array in the central part of the imaging element according to the embodiment.

As illustrated in Figs. 3 and 4, the imaging element 100 includes a pixel array 110 and an optical element array 120 disposed opposite to the pixel array 110. The optical element array 120 is disposed on a side on which the light from the lens optical system 11 is incident. The optical element array 120 is formed on an upper surface of a transparent layer 150 formed on the pixel array 110. A color filter 170 corresponding to each pixel is provided on the pixel array 110. The transparent layer 150 is a transparent layer having a low refractive index made of a material such as $SiO_2$ (refractive index n=1.45) ..

The pixel array 110 has a wire layer 180 and pixels 130 including photoelectric conversion elements placed in a two-dimensional array. The pixel 130 of the pixel unit 140L receives, for example, G light, and the pixel 130 of the pixel unit 140R receives R light.

In the optical element array 120, optical elements made up of a plurality of columnar structures 160 for guiding incident light to photoelectric conversion elements of corresponding pixels 130 immediately below are arranged in a two-dimensional array. For example, Fig. 5 shows a case where the wavelength region separated by the color filter 170 is red (R), green (G), and blue (B) . In the optical element array 120 illustrated in Fig. 5, an optical element unit, in which the R pixel unit that receives R light, the two G pixel units that receive G light, and the B pixel unit that receives B light are disposed to be located immediately below each, on the pixel tray 110, and an optical element unit 120R (optical element) corresponding to the R pixel unit, two optical element units 120G (optical element) corresponding to the G pixel unit, and an optical element unit 120B (optical element) corresponding to the B pixel unit are provide as a set, is formed on a two-dimensional array.

The plurality of columnar structures 160 are formed, using a material having a refractive index higher than that of the surrounding material (transparent layer 150, air). Thus, the columnar structure 160 strongly confines light inside the columnar structure to prevent optical coupling with an adjacent columnar structure. The columnar structure 160 is formed, using, for example, SiN (refractive index n=2.05) and $TiO_2$ (refractive index n=2.4).

As illustrated in Figs. 3 and 4, the plurality of columnar structures 160 are formed at the same height when viewed from the side. The plurality of columnar structures 160 are formed on the entire surface of the optical element array 120 at intervals shorter than the wavelength of incident light. As illustrated in Fig. 5, in the optical element units 120R, 120G and 120B, a plurality of columnar structures 160 are formed in a lattice shape in plan view. The plurality of columnar structures 160 are prisms. The example illustrated in Fig. 5 is an example, and a structure that is subject to four rotations such as a hollow square, a circle, a hollow circle, or a cross when viewed in a plan view may be adopted as the columnar structure.

The plurality of columnar structures 160 are formed in a width w having a phase characteristic for guiding the incident light to the photoelectric conversion element of the corresponding pixel 130 immediately below depending on an incident angle of the incident light of each columnar structure in a plan view. Each of the plurality of columnar structures 160 gives an optical phase delay amount corresponding to a width of the columnar structure 160 in a plan view to incident light.

In the optical element units 120R, 120G and 120B, each of a plurality of columnar structures 160 constituting the optical element units 120R, 120G and 120B has a width that gives an optical phase delay amount distribution for guiding the incident light to each photoelectric conversion element of the corresponding R pixel unit, G pixel unit, and B pixel unit. In the optical element units 120R, 120G, and 120B, the width of each of a plurality of columnar structures 160 forming the optical element units 120R, 120G and 120B in a plan view is set to a width which gives an optical phase delay amount distribution for guiding the incident light to the photoelectric conversion element directly under the optical element units 120R, 120G, and 120B according to the incident angle of the incident light. The optical phase delay amount distribution is an optical phase delay amount for condensing light.

The imaging element 100 achieves a lens function, by forming the columnar structure 160 having the same height and gradually changing width on the entire surface of the optical element array 120. Since each columnar structure 160 behaves like a columnar optical waveguide, in the imaging element 100, the effective refractive index of the columnar structure 160 is changed by changing the width of the columnar structure 160, and the phase of the transmitted light can be freely controlled.

In other words, since each columnar structure 160 behaves as an optical waveguide of sub-wavelength size and has almost no optical coupling with an adjacent columnar structure 160 due to light confinement, by designing the width w of the columnar structure 160 in a plan view for each columnar structure 160, optical characteristics (for example, phase delay characteristic), which are different for each of the plurality of columnar structures 160 can be given. By making the spatial distribution (Fresnel) of the phase delay amount equal to that of the lens, a lens function can be imparted to the columnar structure 160.

Here, a NPL 1 describes that a structure made of a low refractive material such as $SiO_2$ functions as a lens.

In the NPL 1, an approximation is described in which, when the structure is very small compared to the wavelength, the effective refractive index of the structure can be expressed by an approximately average value of the refractive index of the structural lens and the refractive index of the surrounding material. However, when the difference between the refractive index of the structure and the surrounding refractive index is large and the size of the structure is about the sub-wavelength, the light is confined in the structure to excite an optical waveguide mode and a resonance mode, and this approximation cannot be applied. Therefore, since the structure described in the NPL 1 is limited to a combination of materials having a small refractive index difference, in which the material is $SiO_2$ and the surrounding material is air or the like, the aspect ratio of the structure increases.

On the other hand, in the imaging element 100, each columnar structure 160 is formed, using a high refractive index material such as SiN or $TiO_2$. Therefore, the minimum height of the columnar structure 160 required for realizing the phase change amount 0 to $2\pi$ is lower than that of a structure made of a low refractive material such as $SiO_2$ (see, NPL 1) . Therefore, the imaging element 100 can realize a lens function with the columnar structure 160 having a low aspect ratio in which the minimum structure height required for phase control of 0 to $2\pi$ is relatively small and which is easy to manufacture.

The plurality of columnar structures 160 are square columns having a bottom surface. In this way, in the imaging element 100, each columnar structure 160 is formed into a four-fold rotation symmetrical structure such as a square in a plan view, the polarization characteristic is independent of the polarization. It is apparent that the structure described in the NPL 1 has polarization dependence on the effective refractive index by the theoretical formula.

A structure having a curved surface and a step is described in NPL 1. On the other hand, each of the columnar structures 160 in the present embodiment is a prismatic binary pattern having no step. Therefore, since the imaging element 100 can eliminate the curved surface and steps from the cross section of the columnar structure, the columnar structure 160 can be relatively easily formed, as compared with the structure described in the NPL 1.

In addition, in the imaging element 100, since the a lens function is achieved by forming a plurality of columnar structures 160 on the entire surface of the optical element array 120, all incident light can be received, and the lens aperture can be maximized.

Each columnar structure 160 is formed in a width w having a phase characteristic to be guided to a photoelectric conversion element of a pixel 130 immediately below depending on an incident angle of incident light of each columnar structure 160 in a plan view. That is, in the imaging element 100, the structure pattern of the columnar structure 160 can be optimized for each pixel in accordance with the main incident angle for improving the light-receiving efficiency. In other words, in the imaging element 100, the shape pattern of the columnar structure 160 in a plan view is optimized depending on the incident angle θ of light incident on each columnar structure 160.

Thus, in the imaging element 100, the columnar structure 160 can be condensed on the photoelectric conversion element of the pixel 130 immediately below, both in the outer peripheral part (see Fig. 4) on which light is incident at a large incident angle θ and in the central part (see Fig. 3) on which light is incident vertically. Therefore, the imaging element 100 can condense a large amount of light on the photoelectric conversion element immediately below, and can generate an image signal having uniform luminance over the entire imaging element 100.

[Height of Columnar Structure] Next, the height of the columnar structure 160 when viewed from the side will be described. Hereinafter, the height of the columnar structure 160 when viewed from the side is described as a height of the columnar structure 160. The width of the columnar structure 160 in a plan view is described as a width of the columnar structure 160. Here, the minimum height of the columnar structure 160 required for phase control of 0 to $2\pi$ will be described.

A phase delay amount $\phi$ of the columnar structure 160 is expressed by Formula (1), when the wavelength of light in vacuum is defined as $\lambda$, the height of the columnar structure 160 is defined as h, the effective refractive index of the columnar structure 160 is define d as $n_{eff}$, and the refractive index of the surrounding material is defined as no.
[Math. 1]

$$\varphi = (n_{eff} - n_0) \times 2\pi h/\lambda \quad \cdots (1)$$

Formula (1) is also applied to the columnar structure 160 in the imaging element 100, and the structure (hereinafter, referred to as an effective medium approximate structure) described in the NPL 1.

In the case of an effective medium approximation structure, it is known that the effective refractive index $n_{eff}$ is determined by an area ratio of the structure to the surrounding material. In the case of an effective medium approximation structure, the value of $n_{eff}$ is also varied by polarization. In the case of the columnar structure 160, since the optical waveguide mode greatly depends on the width of the columnar structure 160, it is known that the effective refractive index $n_{eff}$ is expressed by a function of the width w of the columnar structure 160. In either case of the effective medium approximate structure or the columnar structure 160, the value of $n_0 < n_{eff} < n_1$ is taken. In addition, $n_1$ is a refractive index of a material constituting the structure.

Therefore, in order to control the amount of phase change in the range of 0 to $2\pi$, it is necessary to set the height of the structure to be represented by Formula (2).
[Math. 2]

$$h \geqq \lambda_0/(n_1 - n_0) \quad \cdots (2)$$

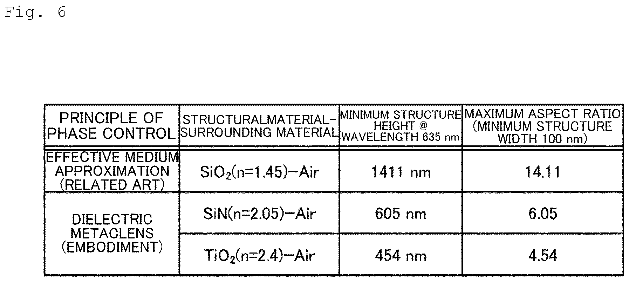

Fig. 6 is a diagram illustrating the minimum structure height and maximum aspect ratio of the effective medium approximation structure of the related art and the columnar structure 160 of the embodiment. In Fig. 6, the maximum aspect ratio is obtained with the minimum structure width of 100 nm when the wavelength of light is 635 nm.

In order to apply the effective medium approximation, it is necessary to reduce $n_1 - n_0$. Therefore, in the case of the effective medium approximate structure, the height of the necessary structure inevitably becomes as high as 1411 nm as illustrated in Fig. 6, and it is necessary to have several wavelengths.

On the other hand, in the case of the columnar structure 160, since the larger $n_1$ is desirable from the viewpoint of light confinement, the value of $n_1$-$n_0$ is larger than that of the effective medium approximate structure. For example, the material for forming the columnar structure 160 is SiN (n=2.05), TiO$_2$ (n=2.4), and $n_1$-$n_0 \geqq 0.7$.

As a result, in the columnar structure 160, the necessary structure height becomes relatively lower than that of the effective medium approximation structure, and as illustrated in Fig. 6, in general, the wavelength is equal to or less than 1 wavelength. Thus, the aspect ratio of the columnar structure 160 is lower than that of the effective medium approximation structure.

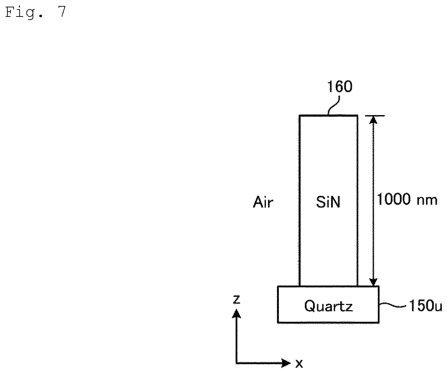

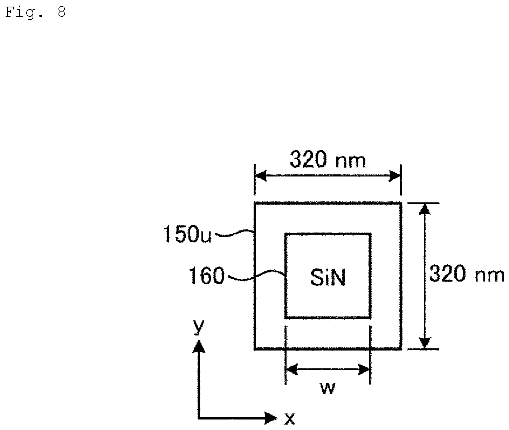

[Structure of Columnar Structure] An example of the structure of the columnar structure 160 will be described. Fig. 7 is a side view of the columnar structure 160. Fig. 8 is a plan view of the columnar structure 160. As illustrated in Figs. 7 and 8, for example, the columnar structure 160 is formed on the upper surface of a transparent layer 150u formed of quartz. Further, the height of the columnar structure 160 (length in a z-axis direction) is set to h=1000 nm, and the arrangement period of the columnar structure 160 is set to 320 nm. The width w of the columnar structure 160 is set corresponding to the phase to be controlled of 0 to $2\pi$.

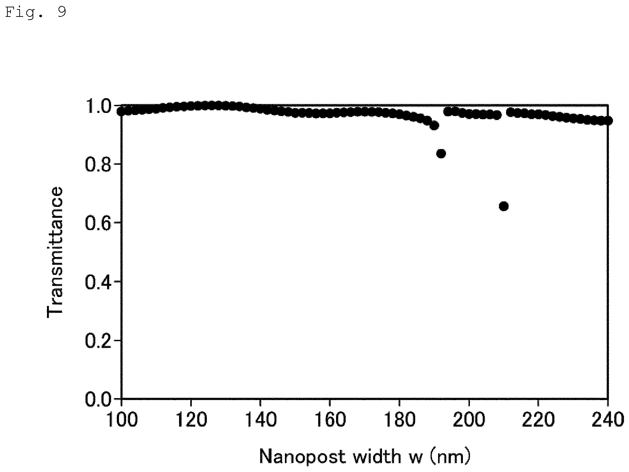

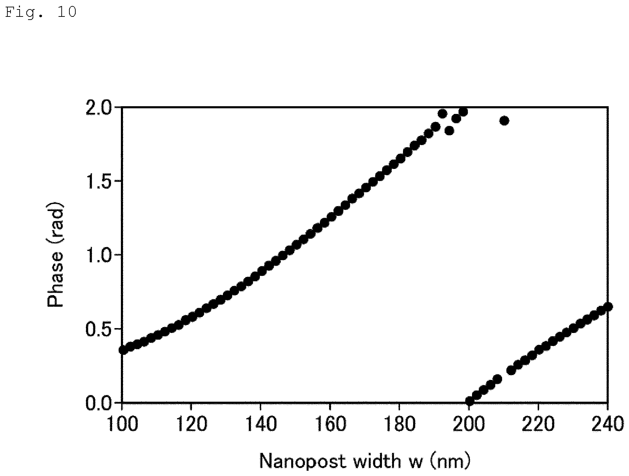

Fig. 9 is a diagram illustrating a relationship between the width w of the columnar structure 160 and the transmittance of light. Fig. 10 is a diagram illustrating a relationship between the width w of the columnar structure 160 and the phase characteristics of the light of the columnar structure 160.

As illustrated in Fig. 9, even when the width w of the columnar structure 160 is changed between 100 and 240 nm, high transmittance can be maintained. By adjusting the width w of the columnar structure 160 between 100 and 240 nm, the phase of light transmitted through the columnar structure 160 can be controlled to a desired phase between

0 and $2\pi$. In Figs. 9 and 10, even when the width of the columnar structure 160 is reduced to 100 nm, the maximum value of the aspect ratio of the columnar structure 160 can be suppressed to 10.

[Design of Lens] In the imaging element 100 according to the present embodiment, the phase distribution of the columnar structure 160 functioning as a lens is designed to condense light at the center of the pixel 130 below the optical element array 120 depending on the incident angle. Further, in the imaging element 100, the width w of the columnar structure 160 is set for each columnar structure 160, while referring to the phase characteristics of Fig. 10 to obtain the designed phase distribution, thereby realizing the ideal phase distribution of the design target.

For example, the parameters of the design example will be described below. The size of one photoelectric conversion element is an area of the lens: 3.2 um × 3.2 um, a focal length: 3.2 um, and a designed wavelength of: 520 nm.

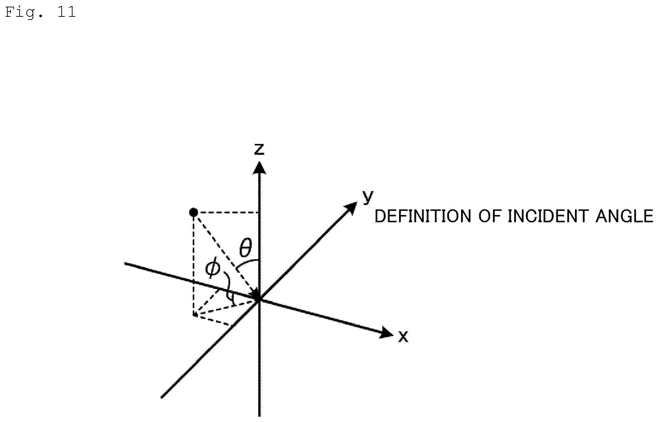

Fig. 11 is a diagram for explaining the definition of the incident angle. As illustrated in Fig. 11, a case where light is incident at an incident angle of $(\theta, \phi)$ is described. A phase distribution $\phi$ of the lens that condenses light at a focal distance f at a point immediately below the center of the lens (columnar structure 160) with respect to light of a certain incident angle $(\theta, \phi)$ is represented by the following Formula (3).

[Math. 3]

$$\varphi(x,y) = -\frac{2\pi}{\lambda_d}\left\{ n_{in}(x\cos\phi + y\sin\phi)\sin\theta + n_{out}\left(\sqrt{x^2 + y^2 + f^2} - f\right)\right\} + C$$

$$\cdots(3)$$

In the formula (3), $\lambda_d$ is the designed wavelength, f is the focal length, $n_{in}$ is a refractive index of a material on the incident side, $n_{out}$ is a refractive index of a material on the emission side, and C is an arbitrary constant.

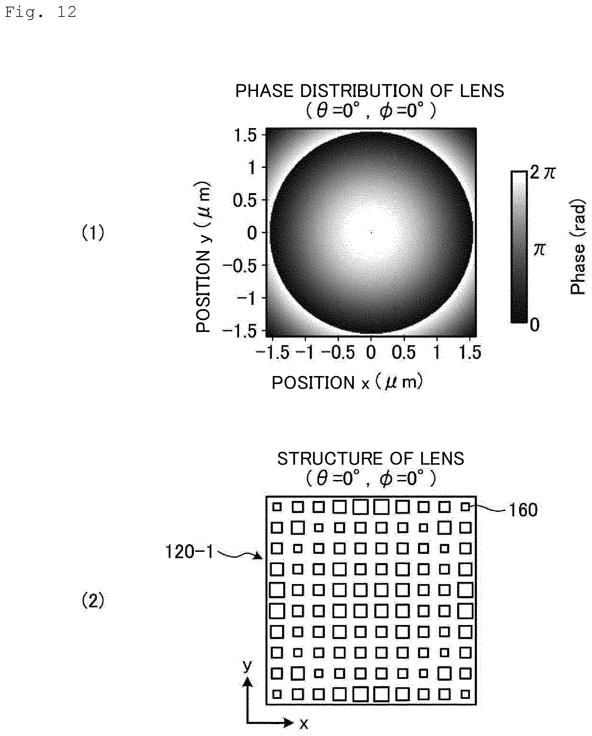

For example, f=3.2 um, $n_{in}$=1.0 (air), $n_{out}$=1.445 (quartz glass) . $\phi$ is converted to fall within the range of 0 to $2\pi$. For example, when $\phi$ is -0.5$\pi$, it is converted to 1.5$\pi$, and when $\phi$ is 2.5$\pi$, it is converted to 0.5. In this setting, the phase distribution of the design target of the lens when light is incident at an arbitrary incident angle, and the lens (columnar structure 160) pattern capable of realizing the phase distribution will be described with reference to Figs. 12 to 14. The phase distribution of the design target of the lens is the phase distribution of the lens which is converged at a focal length f at a point immediately below the center of the lens with respect to the light of a certain incident angle.

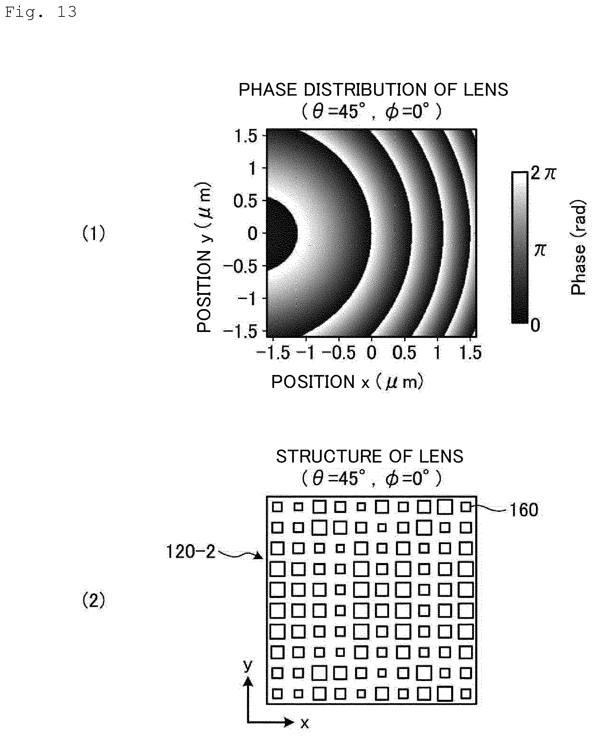

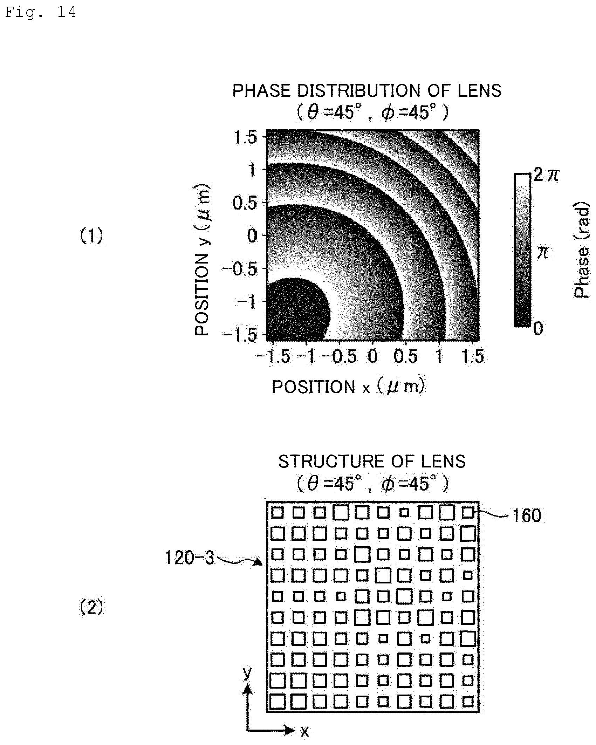

Fig. 12 is a diagram illustrating a phase distribution of a design target of a lens when light enters at an incident angle of $\theta$=0° and $\phi$=0°, and a lens (columnar structure 160) pattern for realizing the phase distribution. Fig. 13 is a diagram illustrating a phase distribution of a design target of a lens when light enters at an incident angle of $\theta$=45° and $\phi$=0° and a lens pattern for realizing the phase distribution. Fig. 14 is a diagram illustrating a phase distribution of a design target of a lens when light enters at an incident angle of $\theta$=45° and $\phi$=45° and a lens pattern for realizing the phase distribution. (1) of Fig. 12, (1) of Fig. 13, and (1) of Fig. 14 are phase distributions of the design target of the lens when light is incident at the incident angle of each condition. (2) of Fig. 12, (2) of Fig. 13, and (2) of Fig. 14 are plan views of the columnar structure 160 capable of realizing the phase distributions of each of (1) of Fig. 12, (1) of Fig. 13, and (1) of Fig. 14, and shape patterns of the columnar structure 160 designed per pixel.

As illustrated in (2) of Fig. 12, (2) of Fig. 13, and (2) of Fig. 14, the columnar structure 160 is a prism having a square bottom surface. Further, the width w of the columnar structure 160 is set to the width capable of realizing the phase at the corresponding position among the phase distributions of (1) of Fig. 12, (1) of Fig. 13, and (1) of Fig. 14, on the basis of the relationship between the width w of the columnar structure 160 and the phase characteristics of the light of the columnar structure 160 illustrated in Fig. 10.

For example, an optical element unit 120-1 illustrated in (2) of Fig. 12 is a shape pattern of the columnar structure 160 which realizes a phase distribution of a design target of a lens when light is incident at an incident angle of $\theta$=0°, $\phi$=0°. An optical element unit 120-2 illustrated in (2) of Fig. 13 is a shape pattern of the columnar structure 160 which realizes a phase distribution of a design target of the lens when light enters at an incident angle of $\theta$=45°, $\phi$=0°. An optical element unit 120-3 illustrated in (2) of Fig. 14 is a shape pattern of the columnar structure 160 which realizes a phase distribution of a design target of the lens when light enters at an incident angle of $\theta$=45°, $\phi$=45°.

[Wavelength Dependence of Condensing Intensity] In the embodiment, the pattern of each columnar structure 160 of the optical element units 120R, 120G and 120B is designed to correspond to the designed wavelength of the photoelectric conversion element of the corresponding immediately lower pixel unit, as in the optical element units 120R, 120G and 120B illustrated in Fig. 5. In the optical element unit, a width w of each of a plurality of columnar structures 160 forming the optical element unit in a plan view is set to a width which gives an optical phase delay amount distribution for guiding light in a wavelength range received by the photoelectric conversion element corresponding to the optical element unit to the photoelectric conversion element corresponding to the optical element unit. Therefore, the wavelength dependence of the condensing intensity by the optical element array 120 will be described.

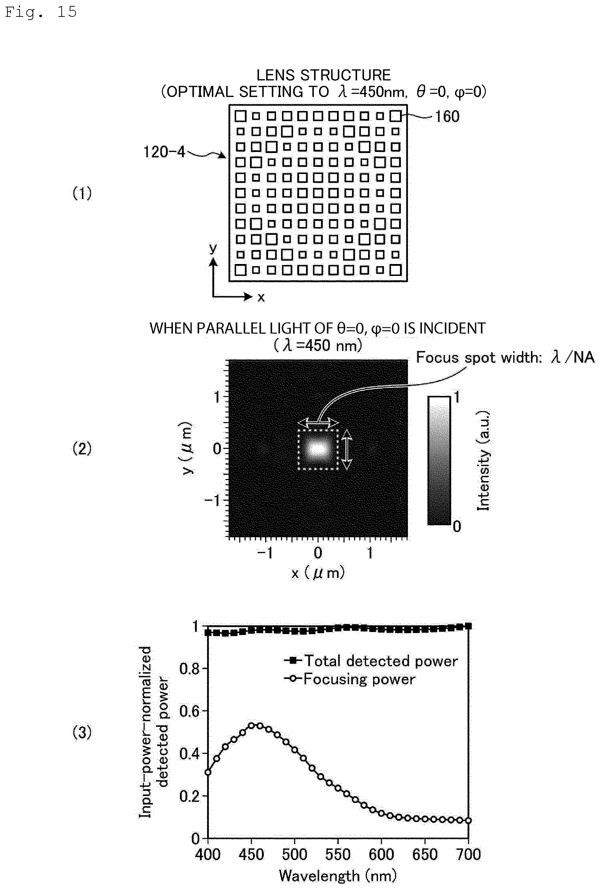

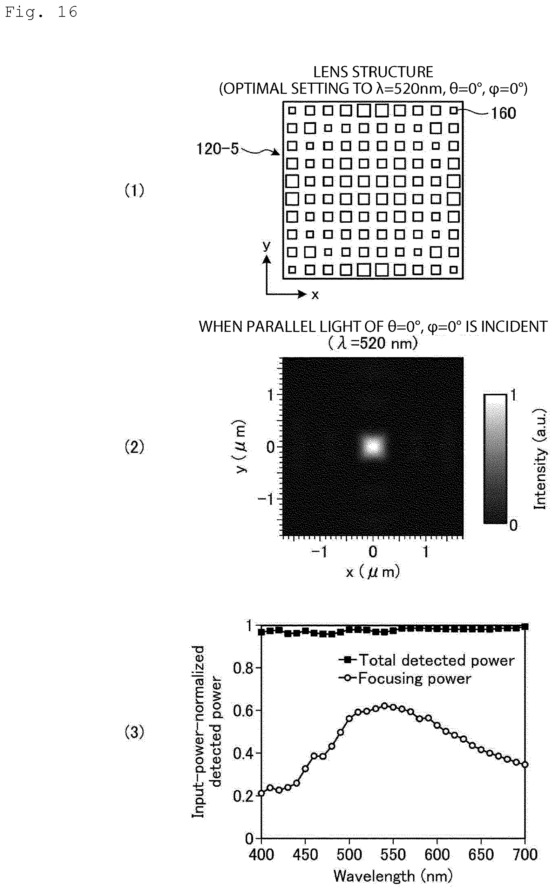

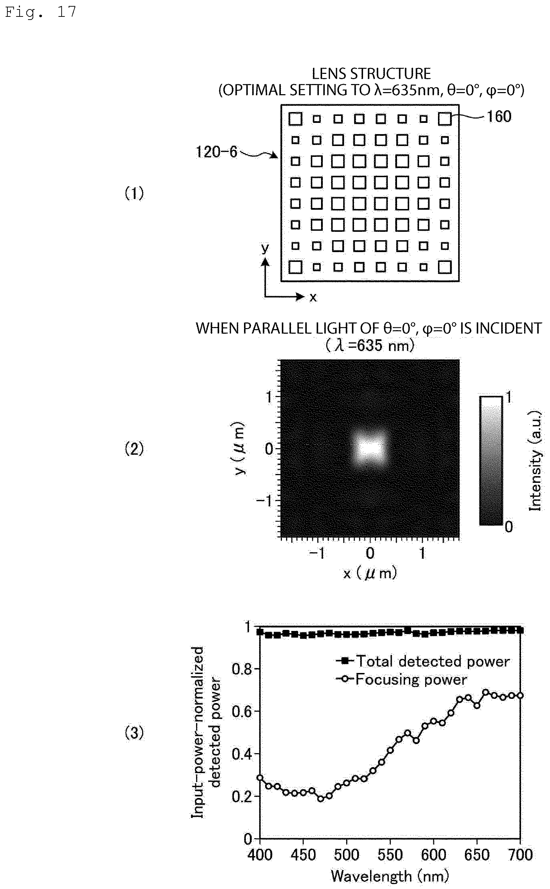

Figs. 15 to 17 are diagrams illustrating the condensing intensity and the wavelength dependency of the condensing intensity by the optical element unit. Fig. 15 corresponds to B light of a wavelength λ=450 nm, Fig. 16 corresponds to G light of a wavelength λ=520 nm, Fig. 17 corresponds to R light of a wavelength λ=635 nm.

(1) of Fig. 15, (1) of Fig. 16, and (1) of Fig. 17 are patterns of the lens (columnar structure 160) designed optimally for the vertical incident light (θ=0°, and φ=0°), and an average of both polarized lights is taken. (2) of Fig. 15, (2) of Fig. 16, and (2) of Fig. 17 are diagrams which illustrate the condensing intensity by the optical element units 120-4, 120-5 and 120-6 of (1) of Fig. 15, (1) of Fig. 16, and (1) of Fig. 17. The condensing intensity is a total intensity inside a condensing spot width (λ/NA, NA is a numerical aperture of a lens) on the photoelectric conversion element surface of the pixel 130. (3) of Fig. 15, (3) of Fig. 16, and (3) of Fig. 17 are diagrams illustrating the wavelength dependency of the condensing intensity by the optical element units 120-4, 120-5, and 120-6.

As illustrated in (3) of Fig. 15, (3) of Fig. 16, and (3) of Fig. 17, it can be seen that in any of the optical element units 120-4, 120-5, and 120-6, 96% or more of the light passes through the structure and can be received by the pixel 130. Further, the condensing intensity of the optical element units 120-4, 120-5, and 120-6 shows the maximum condensing intensity around the design wavelength.

Therefore, in the imaging element 100, only by changing the pattern of the columnar structure 160 such as the optical element units 120-4, 120-5, and 120-6 to correspond to each color band (transmission band of the color filters of R, G, and B), it is possible to design the light condensation according to the design wavelength. In the imaging element 100, a design wavelength of each pixel 130 is determined in accordance with a color filter on the pixel 130, and the optical element units 120-4, 120-5, and 120-6 may each be integrated in accordance with the design wavelength of the pixel 130 immediately below.

[Design Example of Optical Element Unit Corresponding to Incident Angle]

In this embodiment, the pattern of each columnar structure 160 of the optical element unit is designed according to the incident angle of the incident light. In the optical element unit, a width w of each of a plurality of columnar structures 160 forming the optical element unit in a plan view is set to a width which gives an optical phase delay amount distribution for guiding incident light to a photoelectric conversion element immediately below the optical element unit depending on the incident angle of the incident light. Therefore, a design example of the optical element unit corresponding to the incident angle of the incident light to the optical element array 120 will be described.

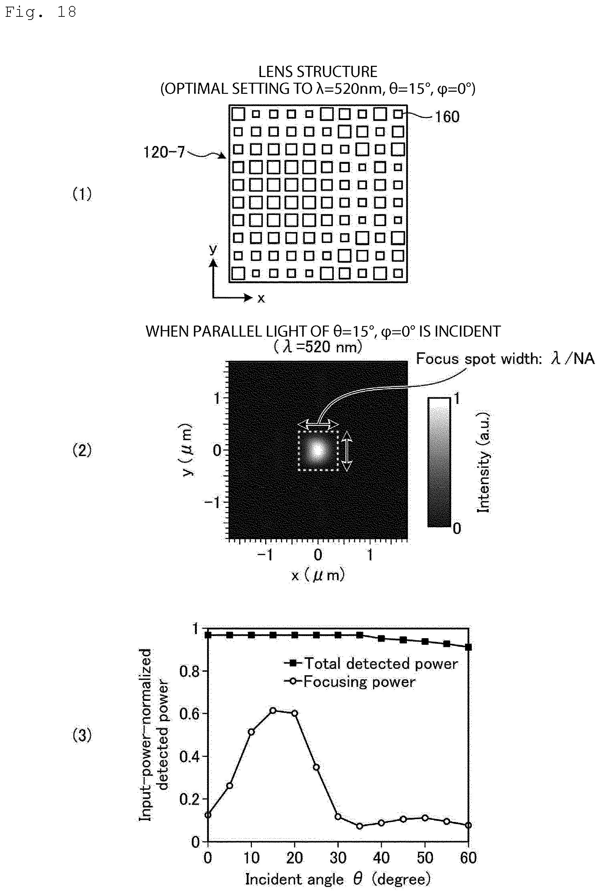

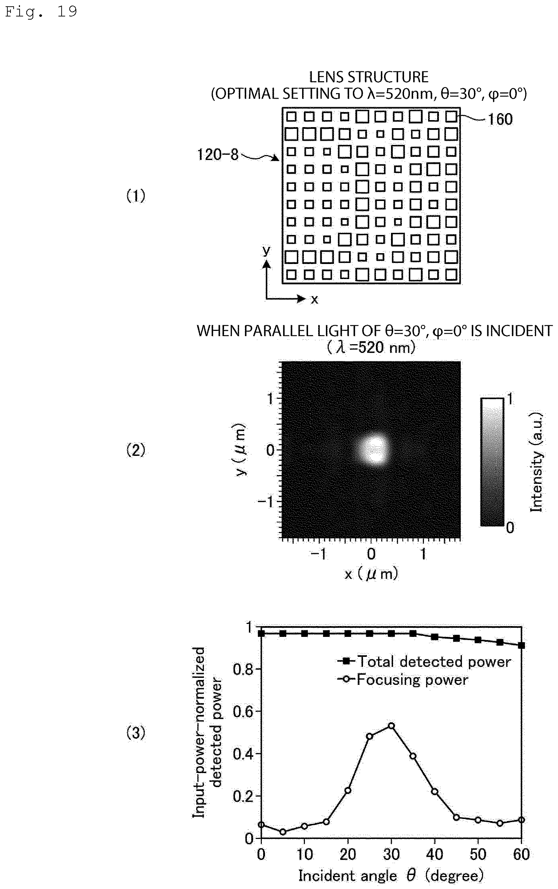

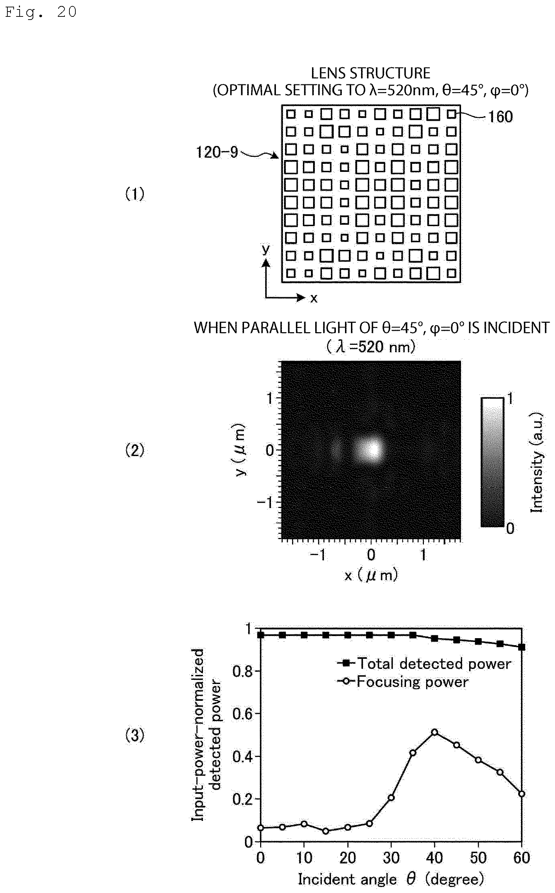

Figs. 18 to 20 are diagrams illustrating the condensing intensity by the optical element unit and the incident angle dependency of the incident light at the time of incidence of the parallel light (λ=520nm) of φ=0°. (1) of Fig. 18 is a pattern of the columnar structure 160 optimally designed for incident light of θ=15°, φ=0°, (1) of Fig. 19 is a pattern of the columnar structure 160 optimally designed for the incident light of θ=30°, φ=0°, and (1) of Fig. 20 is a pattern of the columnar structure 160 optimally designed for the incident light of θ=45°, φ=0°, and an average of both polarizations is taken. (2) of Fig. 18, (2) of Fig. 19, and (2) of Fig. 20 are diagrams which illustrate the condensing intensity by the optical element units 120-7, 120-8 and 120-9 of (1) of Fig. 18, (1) of Fig. 19, and (1) of Fig. 20. (3) of Fig. 18, (3) of Fig. 19, and (3) of Fig. 20 are diagrams which illustrate the incident angle dependence of the condensing intensity by the optical element units 120-7, 120-8, and 120-9.

As illustrated in (3) of Fig. 18, (3) of Fig. 19, and (3) of Fig. 20, the maximum condensing intensity around the designed incident angle is illustrated in any of the optical element units 120-7, 120-8, and 120-9.

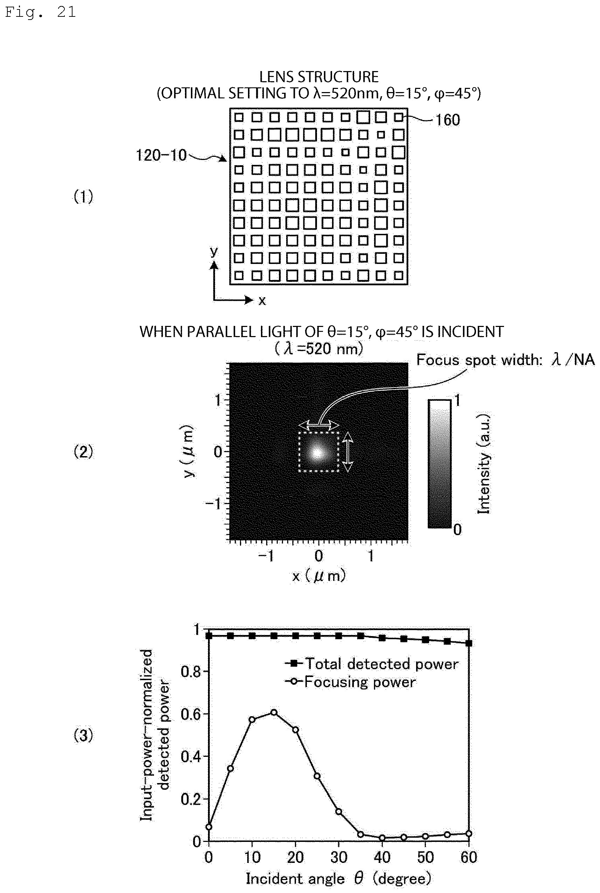

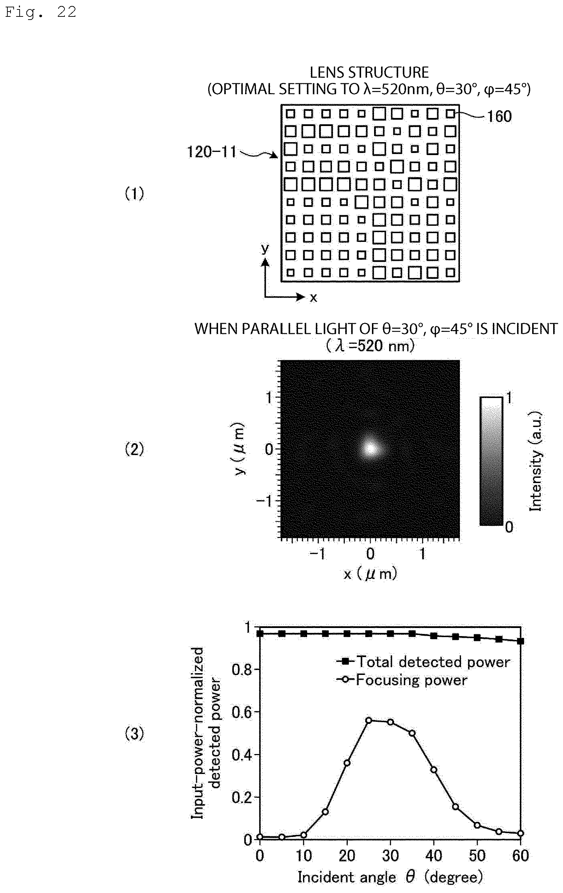

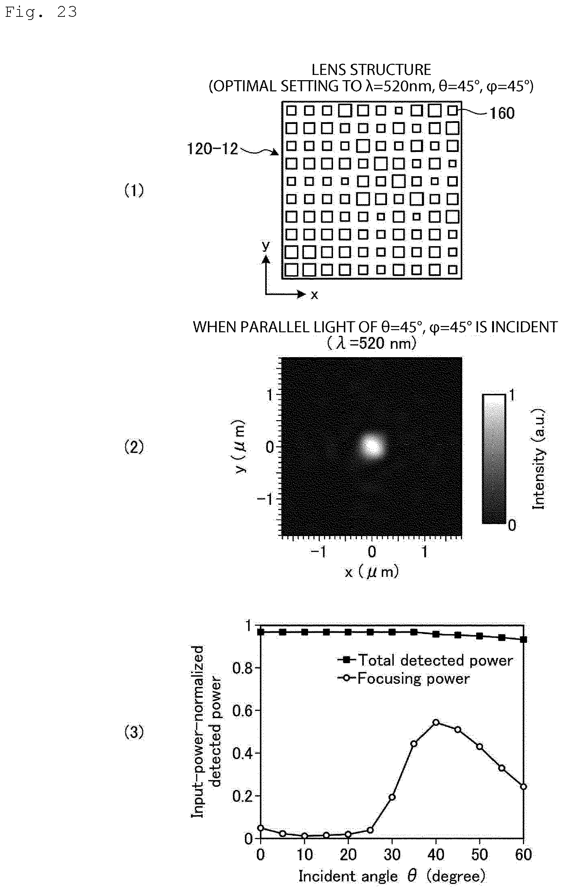

Figs. 21 to 23 are diagrams illustrating the condensing intensity by the optical element unit and the incident angle dependency of the incident light at the time of incidence of parallel light (λ=520 nm) of φ=45°. (1) of Fig. 21 is a pattern of the columnar structure 160 optimally designed for incident light of θ=15°, φ=45°,(1) of Fig. 22 is a pattern of the columnar structure 160 optimally designed for incident light of θ=30°, φ=45°,(1) of Fig. 23 is a pattern of the columnar structure 160 optimally designed for incident light of θ=45°, φ=45°, and the average of both polarized lights is taken. (2) of Fig. 21, (2) of Fig. 22, and (2) of Fig. 23 are diagrams which illustrate the condensing intensity by the optical element units 120-10, 120-11, and 120-12 of (1) of Fig. 21, (1) of Fig. 22, and (1) of Fig. 23. (3) of Fig. 21, (3) of Fig. 22, and (3) of Fig. 23 are diagrams showing the incident angle dependence of the condensing intensity by the optical element units 120-10, 120-11, and 120-12.

As illustrated in (3) of Fig. 21, (3) of Fig. 22 and (3) of Fig. 23, the maximum condensing intensity around the designed incident angle is illustrated in any of the optical element units 120-10, 120-11, and 120-12.

In the imaging element 100, by arranging the above-mentioned optical element units 120-7 to 120-12 to match the incident angle (θ, φ) of incident light, it is possible to condense light with high intensity on the photoelectric conversion element of the pixel 130 immediately below.

[Effects of Embodiment] Thus, in the imaging element 100 according to the embodiment, since the lens function is realized by forming a plurality of columnar structures 160 on the entire surface of the optical element array 120 at intervals shorter than the wavelength of the incident light, all the incident light can be received, and the light-receiving efficiency can be improved.

In the imaging element 100, the plurality of columnar structures are formed at a width having a phase characteristic for guiding the incident light to the photoelectric conversion element immediately below depending on the incident angle of the incident light of each columnar structure in a plan view, and are formed at the same height in a side view. In the imaging element 100, since lens characteristics corresponding to the incident angle can be realized for each pixel 130 by the plurality of columnar structures 160, an image signal having uniform luminance can be generated in the entire imaging element 100.

In the imaging element 100, a plurality of columnar structures 160 formed of a square columnar binary pattern made of a material having a refractive index higher than that of the surrounding material are used as lenses. Therefore, since the plurality of columnar structures 160 in which the imaging element 100 is used as the lenses have a low aspect ratio and a simple configuration as compared with the structures described in the NPL 1, the columnar structures 160 can be easily manufactured.

The optical element unit is not limited to the foregoing configuration and may vary in number, interval, structure shape, and layout pattern. Further, the columnar structures 160 may be connected to each other or may be embedded in a transparent material.

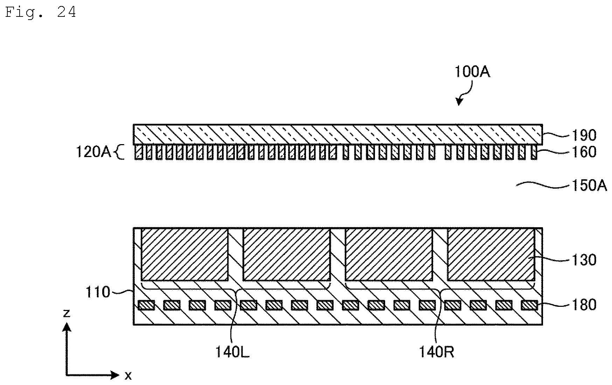

In Figs. 3 and 4, although the optical element array 120 is formed on the upper surface of the transparent layer 150, the embodiment is not limited thereto. Fig. 24 is a diagram schematically illustrating another example of a part of the cross section of the pixel array and the optical element array in the imaging apparatus according to the embodiment. As illustrated in an imaging element 100A of Fig. 24, an optical element array 120A is formed on the bottom surface of an independent transparent substrate 190. In this way, the plurality of columnar structures 160 may be formed inside the transparent layer 150A (for example, air).

Further, in the above, although an example in which four pixels are located immediately below one optical element unit has been described, the present invention is not limited thereto.

Further, in the embodiment, although an example in which SiN and $TiO_2$ are used as the material of the columnar structure 160 is shown, the present invention is not limited thereto. For example, when the imaging apparatuses 100 and 100A are used in the visible light to near infrared light region in which the wavelength of light is in the range of 380 nm to 1000 nm, materials such as SiN, SiC, $TiO_2$, and GaN are suitable for the columnar structure 160 because of the high refractive index and the low absorption loss. When the imaging elements 100 and 100A are used in the near infrared light region having a wavelength in the range of 800 to 1000 nm, materials such as Si, SiC, SiN, $TiO_2$, GaAs, and GaN are suitable as materials for the columnar structure 160 having low loss with respect to the light. Further, in the near infrared region (communication wavelength of 1.3 um, 1.55 um, etc.) of the long wavelength band, InP or the like can be used as the material of the columnar structure 160, in addition to the above-mentioned materials.

When the minute spectral elements of the columnar structure 160 are formed by bonding and coating, polyimide such as fluorinated polyimide, acrylic resin such as BCB (benzocyclobutene), light curing resin, UV epoxy resin and PMMA, polymers such as resists in general, and the like are adopted as materials.

Likewise, in the embodiments, examples, the materials of the transparent layers 150 and 150A include, but not limited to, $SiO_2$ and an air layer. The materials of transparent layers 150 and 150A may be a typical glass material, $SiO_2$, an air layer, and the like, as long as the refractive index is lower than that of the columnar structure 160 and the materials have a low loss with respect to the wavelength of incident light. Alternatively, each of the transparent layers 150 and 150A may be a transparent layer having a multilayer structure made of multiple materials.

In the embodiments, although an example in which the light of wave ranges corresponding to the columnar structure 160 is light of three primary colors R, G, and B, at least one of the three wave ranges may be light (e.g., infrared light or ultraviolet light) with a wavelength other than three primary colors .

In the optical element arrays 120 and 120A, the width of at least a part of the plurality of columnar structures 160 in a plan view is set to a width which gives an optical phase delay amount distribution for guiding the incident light to the corresponding photoelectric conversion element immediately below, on the basis of the relationship between the width of the columnar structure 160 illustrated in Fig. 10 and the phase characteristic of the light. Thus, in the optical element arrays 120 and 120A, lens characteristics corresponding to the incident angle and the wavelength range in the photoelectric conversion element are realized for each pixel 130. In the present embodiment, the plurality of columnar structures 160 may have a refractive index such that the plurality of columnar structures 160 have a phase characteristic for guiding the incident light to the photoelectric conversion element immediately below in accordance with the incident angle of the incident light of each columnar structure, without being limited thereto. In other words, in the present embodiment, it is possible to realize lens characteristics corresponding to the incident angle and the wavelength range of the photoelectric conversion element for each pixel 130, by setting the plurality of columnar structures 160 to have different refractive indexes from each other. In the present embodiment, since the width of the columnar structure 160 in a plan view and the refractive index of the columnar structure value 160 are changed for each columnar structure, it is possible to realize lens characteristics corresponding to an incident angle and a wavelength range in the photoelectric conversion element for each pixel 130.

The optical element arrays 120 and 120A of the present embodiment is, for example, a meta-surface. As described above, the meta-surface is an element including a plurality of fine structures having a width equal to or less than the wavelength of light, and may have a two-dimensional structure or a three-dimensional structure. By using the meta-surface as the optical element array, the phase and the light intensity can be controlled depending on the characteristics (wavelength, polarization and incident angle) of light, only by changing the parameter of the fine structure. In the case where the meta-surface has a three-dimensional structure, the degree of freedom in design is increased.

The present invention was described based on the specific embodiments. It is obvious that the present invention is not limited to the foregoing embodiments and can be changed in various ways within the scope of the invention.

[Reference Signs List]

1 Object
10 Imaging apparatus
11 Lens optical system
12, 100, 100AImaging element
13 Signal processing unit
110 Pixel array
120, 120A Optical element array
120R, 120G, 120B, 120-1 to 120-12 Optical element unit
130 Pixel
140L, 140R Pixel unit
150, 150A Transparent layer
160 Columnar structure
170 Color filter
180 Wire layer
190 Transparent substrate

**Claims**

1. An optical element comprising:

   a transparent layer for covering a pixel including a photoelectric conversion element; and
   a plurality of columnar structures which are disposed on the transparent layer or in the transparent layer in a plane direction of the transparent layer and guide incident light to the corresponding photoelectric conversion element,
   wherein the plurality of columnar structures are formed on an entire surface of the transparent layer at intervals shorter than a wavelength of the incident light.

2. The optical element according to claim 1, wherein the plurality of columnar structures are formed in a lattice shape in a plan view.

3. The optical element according to claim 1 or 2,

   wherein the plurality of columnar structures have a refractive index higher than that of a surrounding material of the plurality of columnar structures, and
   in a plan view, at least some columnar structures of the plurality of columnar structures have widths different from each other, and
   in a side view, the plurality of columnar structures have a same height.

4. The optical element according to claim 1 or 2,

   wherein the plurality of columnar structures have a refractive index higher than that of a surrounding material of the plurality of columnar structures, at least some columnar structures of the plurality of columnar structures have refractive indices different from each other, and
   in a side view, the plurality of columnar structures have a same height.

5. The optical element according to any one of claims 1 to 3,

wherein each of the plurality of columnar structures gives an optical phase delay amount, according to a width of the columnar structures when viewed in a plan view, to the incident light, and

the optical element has a width in which each of the plurality of columnar structures constituting the optical element gives an optical phase delay amount distribution for guiding the incident light to the corresponding photoelectric conversion element.

6. The optical element according to claim 5, wherein, in the optical element, a width of each of a plurality of columnar structures constituting the optical element when viewed in a plan view is set to a width which gives an optical phase delay amount distribution for guiding light of a wavelength range received by the photoelectric conversion element corresponding to the optical element to the photoelectric conversion element corresponding to the optical element.

7. The optical element according to claim 6, wherein a width of each of the plurality of columnar structures in a plan view is set to a different value for each wavelength range in the corresponding photoelectric conversion element.

8. The optical element according to claim 6 or 7, wherein the optical phase delay amount distribution is an optical phase delay amount for condensing light.

9. The optical element according to any one of claims 1 to 7, wherein the plurality of columnar structures are formed using a material having a refractive index higher than that of the transparent layer.

10. The optical element according to any one of claims 1 to 9, wherein the plurality of columnar structures have a four-fold rotationally symmetric structure in a plan view.

11. An imaging element comprising:

the imaging element according to any one of claims 1 to 10; and
a plurality of pixels each including the photoelectric conversion element.

12. An imaging apparatus comprising:

the imaging element according to claim 11; and
a signal processing unit configured to process an electric signal output from the imaging element and generate an image.

Fig. 1

Fig. 2

INCIDENT
ANGLE θ

11

100

Fig. 3

Fig. 4

INCIDENT LIGHT

100

120{ 〰〰〰〰〰〰〰〰〰〰〰〰〰〰〰〰〰 160

150

170

130

110 180

140L 140R

z

x

Fig. 5

Fig. 6

| PRINCIPLE OF PHASE CONTROL | STRUCTURAL MATERIAL– SURROUNDING MATERIAL | MINIMUM STRUCTURE HEIGHT @ WAVELENGTH 635 nm | MAXIMUM ASPECT RATIO (MINIMUM STRUCTURE WIDTH 100 nm) |
|---|---|---|---|
| EFFECTIVE MEDIUM APPROXIMATION (RELATED ART) | $SiO_2(n=1.45)$–Air | 1411 nm | 14.11 |
| DIELECTRIC METACLENS (EMBODIMENT) | $SiN(n=2.05)$–Air | 605 nm | 6.05 |
| | $TiO_2(n=2.4)$–Air | 454 nm | 4.54 |

Fig. 7

Fig. 8

Fig. 9

Fig. 10

Fig. 11

DEFINITION OF INCIDENT ANGLE

Fig. 12

(1)

PHASE DISTRIBUTION OF LENS
($\theta$ =0° , $\phi$ =0° )

(2)

STRUCTURE OF LENS
($\theta$ =0° , $\phi$ =0° )

120-1

160

y
x

Fig. 13

(1)

PHASE DISTRIBUTION OF LENS
($\theta$ =45°, $\phi$ =0°)

(2)

STRUCTURE OF LENS
($\theta$ =45°, $\phi$ =0°)

Fig. 14

(1)

PHASE DISTRIBUTION OF LENS
($\theta$ =45°, $\phi$ =45°)

(2)

STRUCTURE OF LENS
($\theta$ =45°, $\phi$ =45°)

Fig. 15

(1)

LENS STRUCTURE
(OPTIMAL SETTING TO $\lambda$ =450nm, $\theta$ =0, $\varphi$=0)

120-4

160

y

x

(2)

WHEN PARALLEL LIGHT OF $\theta$=0, $\varphi$=0 IS INCIDENT
( $\lambda$ =450 nm)

Focus spot width: $\lambda$ /NA

y ( $\mu$ m)

x ( $\mu$ m)

Intensity (a.u.)

(3)

Input-power-normalized detected power

-■-Total detected power
-○-Focusing power

Wavelength (nm)

Fig. 16

(1)

LENS STRUCTURE
(OPTIMAL SETTING TO λ=520nm, θ=0°, φ=0°)

120-5

160

y

x

(2)

WHEN PARALLEL LIGHT OF θ=0°, φ=0° IS INCIDENT
( $\lambda$ =520 nm)

(3)

Fig. 17

LENS STRUCTURE
(OPTIMAL SETTING TO λ=635nm, θ=0°, φ=0°)

(1)

WHEN PARALLEL LIGHT OF θ=0°, φ=0° IS INCIDENT
( λ =635 nm)

(2)

(3)

Fig. 18

(1)

LENS STRUCTURE
(OPTIMAL SETTING TO λ=520nm, θ=15°, φ=0°)

(2)

WHEN PARALLEL LIGHT OF θ=15°, φ=0° IS INCIDENT
(λ =520 nm)

(3)

Fig. 19

LENS STRUCTURE
(OPTIMAL SETTING TO λ=520nm, θ=30°, φ=0°)

160

120-8

(1)

y

x

WHEN PARALLEL LIGHT OF θ=30°, φ=0° IS INCIDENT
( λ =520 nm)

(2)

(3)

Fig. 20

LENS STRUCTURE
(OPTIMAL SETTING TO λ=520nm, θ=45°, φ=0°)

(1)

WHEN PARALLEL LIGHT OF θ=45°, φ=0° IS INCIDENT
($\lambda$ =520 nm)

(2)

(3)

Fig. 21

(1)

LENS STRUCTURE
(OPTIMAL SETTING TO λ=520nm, θ=15°, φ=45°)

(2)

WHEN PARALLEL LIGHT OF θ=15°, φ=45° IS INCIDENT
(λ=520 nm)

Focus spot width: λ/NA

(3)

Fig. 22

(1)

LENS STRUCTURE
(OPTIMAL SETTING TO λ=520nm, θ=30°, φ=45°)

120-11

160

y
→ x

(2)

WHEN PARALLEL LIGHT OF θ=30°, φ=45° IS INCIDENT
( $\lambda$ =520 nm)

(3)

Fig. 23

(1)

LENS STRUCTURE
(OPTIMAL SETTING TO λ=520nm, θ=45°, φ=45°)

(2)

WHEN PARALLEL LIGHT OF θ=45°, φ=45° IS INCIDENT
( $\lambda$ =520 nm)

(3)

Fig. 24

Fig. 25

Fig. 26

**INTERNATIONAL SEARCH REPORT**

| International application No. |
| --- |
| PCT/JP2020/038499 |

**A. CLASSIFICATION OF SUBJECT MATTER**
Int. Cl. G02B3/00(2006.01)i, H01L27/146(2006.01)i, H04N5/369(2011.01)i, H04N9/07(2006.01)i
FI: H01L27/146 D, H04N5/369, H04N9/07 D, G02B3/00 A
According to International Patent Classification (IPC) or to both national classification and IPC

**B. FIELDS SEARCHED**

Minimum documentation searched (classification system followed by classification symbols)
Int. Cl. G02B3/00, H01L27/146, H04N5/369, H04N9/07

Documentation searched other than minimum documentation to the extent that such documents are included in the fields searched
Published examined utility model applications of Japan 1922-1996
Published unexamined utility model applications of Japan 1971-2020
Registered utility model specifications of Japan 1996-2020
Published registered utility model applications of Japan 1994-2020

Electronic data base consulted during the international search (name of data base and, where practicable, search terms used)

**C. DOCUMENTS CONSIDERED TO BE RELEVANT**

| Category* | Citation of document, with indication, where appropriate, of the relevant passages | Relevant to claim No. |
| --- | --- | --- |
| X | JP 2010-212625 A (NIKON CORP.) 24 September 2010 (2010-09-24), paragraphs [0018]-[0045], fig. 1-9 | 1-3, 5-12 |
| Y | | 1-12 |
| Y | JP 2009-157390 A (PANASONIC CORP.) 16 July 2009 (2009-07-16), paragraphs [0059]-[0091], [0105]-[0125], fig. 5-17, 30-39 | 1-12 |
| A | JP 2019-184986 A (NIPPON TELEGRAPH AND TELEPHONE CORP.) 24 October 2019 (2019-10-24), entire text, all drawings, (in particular, paragraph [0049]) | 1-12 |
| A | JP 2020-51868 A (NIPPON TELEGRAPH AND TELEPHONE CORP.) 02 April 2020 (2020-04-02), entire text, all drawings | 1-12 |

☒ Further documents are listed in the continuation of Box C.  ☒ See patent family annex.

| * | Special categories of cited documents: | "T" | later document published after the international filing date or priority date and not in conflict with the application but cited to understand the principle or theory underlying the invention |
| --- | --- | --- | --- |
| "A" | document defining the general state of the art which is not considered to be of particular relevance | | |
| "E" | earlier application or patent but published on or after the international filing date | "X" | document of particular relevance; the claimed invention cannot be considered novel or cannot be considered to involve an inventive step when the document is taken alone |
| "L" | document which may throw doubts on priority claim(s) or which is cited to establish the publication date of another citation or other special reason (as specified) | "Y" | document of particular relevance; the claimed invention cannot be considered to involve an inventive step when the document is combined with one or more other such documents, such combination being obvious to a person skilled in the art |
| "O" | document referring to an oral disclosure, use, exhibition or other means | | |
| "P" | document published prior to the international filing date but later than the priority date claimed | "&" | document member of the same patent family |

| Date of the actual completion of the international search | Date of mailing of the international search report |
| --- | --- |
| 01.12.2020 | 08.12.2020 |

| Name and mailing address of the ISA/ | Authorized officer |
| --- | --- |
| Japan Patent Office 3-4-3, Kasumigaseki, Chiyoda-ku, Tokyo 100-8915, Japan | Telephone No. |

Form PCT/ISA/210 (second sheet) (January 2015)

**INTERNATIONAL SEARCH REPORT**

| International application No. |
| --- |
| PCT/JP2020/038499 |

C (Continuation).   DOCUMENTS CONSIDERED TO BE RELEVANT

| Category* | Citation of document, with indication, where appropriate, of the relevant passages | Relevant to claim No. |
| --- | --- | --- |
| A | JP 2011-40441 A (PANASONIC CORP.) 24 February 2011 (2011-02-24), entire text, all drawings | 1-12 |
| A | US 2017/0034500 A1 (SAMSUNG ELECTRONICS CO., LTD.) 02 February 2017 (2017-02-02), entire text, all drawings | 1-12 |

Form PCT/ISA/210 (continuation of second sheet) (January 2015)

| | International application No. |
|---|---|
| | PCT/JP2020/038499 |

| Patent Documents referred to in the Report | Publication Date | Patent Family | Publication Date |
|---|---|---|---|
| JP 2010-212625 A | 24.09.2010 | (Family: none) | |
| JP 2009-157390 A | 16.07.2009 | US 2008/0272454 A1 paragraphs [0167]-[0194], [0208]-[0227], fig. 5-17, 30-39 WO 2006/025496 A1 EP 1785750 A1 CN 1993634 A | |
| JP 2019-184986 A | 24.10.2019 | WO 2019/202890 A1 KR 10-2020-0029572 A | |
| JP 2020-51868 A | 02.04.2020 | WO 2020/066738 A1 | |
| JP 2011-40441 A | 24.02.2011 | (Family: none) | |
| US 2017/0034500 A1 | 02.02.2017 | KR 10-2017-0015108 A | |

Form PCT/ISA/210 (patent family annex) (January 2015)

**REFERENCES CITED IN THE DESCRIPTION**

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- JP 2012084608 A